# EUROPÄISCHE PATENTSCHRIFT

(11) **EP 3 179 617 B1**
(45) Veröffentlichungstag und Bekanntmachung des Hinweises auf die Patenterteilung: **03.10.2018**
(21) Anmeldenummer: 15198567.8
(22) Anmeldetag: 09.12.2015
(51) Int. Cl.: H02M 1/12

(54) **SCHALTUNGSANORDNUNG ZUR KOMPENSATION EINES GLEICHSTROMANTEILS IN EINEM TRANSFORMATOR**
CIRCUIT ASSEMBLY FOR THE COMPENSATION OF A DC COMPONENT IN A TRANSFORMER
CIRCUIT DE COMPENSATION D'UNE PARTIE DE COURANT CONTINU DANS UN TRANSFORMATEUR

(43) Veröffentlichungstag der Anmeldung: 14.06.2017
(73) Patentinhaber: Siemens Aktiengesellschaft, 80333 München (DE)
(72) Erfinder: Hamberger, Peter, 4202 Kirchschlag bei Linz (AT)
(74) Vertreter: Maier, Daniel Oliver

(56) Entgegenhaltungen:
- WO-A1-2015/086048
- WO-A2-2004/013951
- CN-A- 103 943 340
- DE-A1- 3 631 438

## Beschreibung

### Technisches Gebiet

Die Erfindung betrifft allgemein elektrische Transformatoren wie Sie in Netzen zur Erzeugung, Übertragung und Verteilung elektrischer Energie eingesetzt werden, insbesondere eine Schaltungsanordnung zur Kompensation eines Gleichstromanteils in einem Transformator, wobei der Transformator eine Wicklungsanordnung die mittels Anschlussleiter am Netz angeschlossen ist und einen mit Erde verbundenen Sternpunkt aufweist.

### Stand der Technik

In Netzen zur Erzeugung, Übertragung und Verteilung elektrischer Energie kann es aus unterschiedlichen Gründen zur Ausbildung eines Gleichstroms kommen, der sich anteilig dem Wechselstrom überlagert. Ein solcher Gleichstromanteil, im Folgenden auch als DC-Anteil genannt, kann beispielsweise durch einen am Netz angeschlossenen Stromrichter hervorgerufen werden oder ein so genannter "Geomagnetically Induced Current" (GIC) sein.

Ein GIC wird durch Solarwind verursacht, indem sich das Erdmagnetfeld ändert, so dass in einer von Netzleitungen und Erdrückleitung aufgespannten Leiterschleife ein Flussänderung entsteht und die darin induzierte elektrische Spannung den GIC erzeugt. Der GIC ist zeit- und richtungsabhängig. Die Geschwindigkeit mit der sich der GIC ändert ist aber vergleichsweise so langsam, dass er im Netz als DC-Anteil betrachtet werden kann.

Unabhängig von seiner Ursache ist ein DC-Anteil in einem Transformator stets unerwünscht, da mit ihm ein magnetischer Gleichflussanteil einhergeht, der sich im Kern des Transformators dem magentischen Wechselfluss überlagert, wodurch die Aussteuerung des Transformatorkerns nicht mehr symmetrische ist. Es kommt zu einer Verschiebung des Arbeitspunktes des magnetischen Werkstoffs. Je nach Bauart des Transformators kann schon ein sehr geringer Gleichstromanteil von einigen 100 mA die Emission der Betriebsgeräusche um 10 bis 20 dB erhöhen. Die Verschiebung des Arbeitspunktes des magnetischen Werkstoffs kann zu einer signifikanten Erhöhung der Verluste im Bereich von 20-30 % führen. Lokal kann es zu einer erhöhten Erwärmung im Transformator kommen, wodurch die Lebensdauer der Isolation der elektrischen Wicklung beeinträchtigt werden kann. Bei einem großen GIC kann es zu Heißstellen an metallischen Teilen und zur Zersetzung der Isolierflüssigkeit kommen, was zur Entstehung von Spaltgasen führen kann.

Zur Verringerung eines Gleichflussanteils im Kern eines Transformators sind verschiedene Verfahren und Vorrichtungen bekannt. Beispielsweise wird in der EP 2 622 614 B1 vorgeschlagen, den Transformatorkern mit einer Kompensationswicklung zu versehen und in diese mittels einer Halbleiter-Schaltvorrichtung einen Kompensationsstrom einzuspeisen, dessen Wirkung dem störenden Gleichflussanteil entgegen gerichtet ist. Der Vorteil ist dabei, dass diese Kompensationswicklung galvanisch vom Energienetz getrennt ist, d.h. keine Verbindung zum Primär- oder sekundären Wicklungssystem des Transformators aufweist.

Nun kann eine solche Kompensationswicklung, wenn Sie bereits bei der Herstellung des Transformators vorgesehen ist, mit vertretbaren Kosten realisiert werden. Je nach Größe des zu kompensierenden DC-Anteils ist konstruktiv ein entsprechend großer Einbauraum vorzusehen, wodurch sich die Abmessungen des Transformatorkerns ändern.

Verglichen hierzu ist eine Nachrüstung weitaus aufwändiger und praktisch kaum von Bedeutung. Wenn ein bereits in Betrieb befindlicher Transformator mit einer DC-Kompensation nachgerüstet werden soll, muss der Transformator vom Netz genommen werden und die Kompensationswicklung muss im Innenraum des Transformatorkessels installiert werden. Oft ist ein nachträglicher Einbau einer Kompensationswicklung überhaupt nicht möglich. In jedem Fall sind die Kosten eines nachträglichen Einbaus sehr hoch, so dass eine Nachrüstung bislang kaum durchgeführt wurde.
Einschränkungen ergeben sich auch durch Grenzbelastung verfügbarer Halbleiter-Bauelemente. Bei Transformatoren, die im Rahmen einer Hochspannung-Gleichstrom-Übertragung (HGÜ) eingesetzt werden, kann in einer Kompensationswicklung eine induzierte Spannung von mehreren 1000 V induziert werden. Zum anderen kann ein GIC eine Stromstärke von mehr als 50 A erreichen, wodurch die schaltungstechnische Realisierung aufwändig ist.
Problematisch ist auch die Anordnung von HalbleiterBauelementen mit begrenzter Lebensdauer im Innenraum eines Leistungs- oder Verteilertransformators, die für einen störungsfreien Betrieb über mehrere Jahrzehnte ausgelegt sind.

Weitere Beispiele von Gleichstromanteilkompensation bei Transformatoren sind in WO2004/013951, CN 103 943340, WO2015/086048 und DE 36 31 438 gezeigt.

### Darstellung der Erfindung

Es ist eine Aufgabe der vorliegenden Erfindung einen möglichst einfachen und robusten Ansatz für die Kompensation eines Gleichstromanteils zu schaffen, der auch an bereits in Betrieb befindlichen Transformatoren kostengünstig realisiert werden kann und der darüber hinaus eine lange Betriebsdauer sowie eine hohe Zuverlässigkeit erwarten lässt.
Diese Aufgabe wird durch eine Schaltungsanordnung gemäß den Merkmalen des Anspruchs 1 und den Merkmalen des Verfahrens des Anspruchs 12 gelöst.

Weitere vorteilhafte Ausgestaltungen der Erfindung ergeben sich aus den abhängigen Ansprüchen, der Beschreibung und der beigefügten Zeichnung.

In einem Grundgedanken geht der vorliegende Ansatz davon aus, die Kompensation eines DC-Anteils nicht mit Baukomponenten im Innenraum des Transformators zu bewerkstelligen, sondern - ähnlich einer Schutzeinrichtung - außerhalb des Transformatorgehäuses, wobei eine separate Kompensationswicklung nicht erforderlich ist.

Ausgehend von einem Transformator, dessen Wicklungsanordnung netzseitig mittels Anschlussleiter an ein Netz zum Transport von elektrischer Energie angeschlossen ist und einen mit Erde verbundenen Sternpunkt aufweist, umfasst die Schaltungsanordnung:
- eine Transduktor-Schaltung, welche in einem Strompfad angeordnet ist, der einen auf einem knotenfreien Abschnitt der Anschlussleiter liegenden Anschlusspunkt mit Erde verbindet, und
- eine Steuer- und Regeleinrichtung, welche die Transduktor-Schaltung mittels eines Steuersignals steuert, der eingangsseitig ein von einer Erfassungseinrichtung bereitgestelltes Signal über Größe und Richtung des zu kompensierenden Gleichstromanteils zugeleitet ist.

Die Transduktor-Schaltung fungiert als magnetischer Schalter. Die Funktion eines Transduktors ist an sich bekannt, sie braucht hier nicht näher erläutert werden. Von Vorteil ist, dass die Transduktor-Schaltung keine aktiv wirkenden Bauelemente, z.B. gesteuerte Halbleiter-Ventile aufweist, sondern nur passiv wirkende. Diese sind in einem Strompfad angeordnet, der einen knotenfreien Abschnitt jeder Zuleitung zum Transformator mit Erde verbindet. Gesteuert wird die Transduktor-Schaltung von einer Steuereinheit, der eine Information über Größe und Richtung des zu kompensierenden DC-Anteils zugeleitet ist. Eine solche Information kann beispielsweise von einem Sensor im Innenraum des Transformators herrühren, zum Beispiel ein Magnetfeldsensor, der den störenden Gleichflussanteil im Kern des Transformators misst, oder aber auch aus dem Netz gewonnen wird, zum Beispiel durch Messung des Gleichstromanteils in einer Netzleitung (was allerdings aufgrund der stark unterschiedlichen Größen von Netzstrom und DC-Anteil technisch aufwändig ist). Denkbar sind auch andere im Netz installierte Messeinrichtungen, die einen GIC detektierten bzw. prognostizieren.

Der mit einer Schaltungsanordnung gemäß Anspruch 1 erzielte technische Effekt ähnelt dem einer "DC-Weiche", die als Schutzeinrichtung wirkt: der störende DC-Anteil wird durch gezielte Ansteuerung der im Strompfad zwischen Transformatorzuleitung und Erde liegenden Transduktor-Schaltung zur Erde hin "abgeleitet". Damit wird dem DC-Anteil bereits im Vorfeld entgegengewirkt, so dass er nicht - zumindest nicht in seiner vollen Größe - zum Transformator gelangt. Für diese "Kompensation", die bereits in der Zuleitung stattfindet, ist eine separate, mit dem Transformatorkern magnetisch gekoppelte Kompensationswicklung, wie Sie sonst für diesen Zweck üblich ist, nicht mehr erforderlich. Mit der vorliegenden Schaltungsanordnung kann ein DC-Anteil auch von mehr als 50 A, z.B. ein großer GIC, auf vergleichsweise einfache Weise beherrscht werden. Beides ist von großem Vorteil. Demgegenüber steht allerdings das Erfordernis, dass die Schaltungsanordnung mit allen im Transduktor-Strompfad liegenden Baukomponenten entsprechend dem Spannungsniveau der Transformatorzuleitung ausgelegt sein muss, zum Beispiel 20 KV oder 120 KV oder mehr. Die oben genannten Vorteile überwiegen aber diesen Mehraufwand.

Wie bereits gesagt, befinden sich jene Baukomponenten, die den DC-Anteil ableiten, außerhalb des Transformatorgehäuses. Sie wirken rein passiv. Die Wartung ist einfach möglich. Die Zuverlässigkeit der Schaltungsanordnung ist hoch.

Anstelle der sonst üblichen leistungselektronischen Baukomponenten (zum Beispiel Thyristor) wird hier für die Erzeugung eines Kompensationsstroms ein "induktiv wirkender Schalter", eine Transduktor-Schaltung verwendet. Die Baukomponenten einer Transduktor-Schaltung, Magnetspulen und ungesteuerte Ventile, lassen eine lange Lebensdauer und einen über viele Jahre störungsfreien Betrieb erwarten. Seitens der Netzbetreiber ist die Akzeptanz eines Transformators mit einer solchen DC-Kompensationseinrichtung daher hoch.

In einer bevorzugten Ausführung kann die Schaltungsanordnung als Transduktor-Schaltung mit zwei parallelen Stromzweigen ausgeführt sein. In jedem dieser Stromzweige ist jeweils eine Transduktor-Arbeitswicklung und in Reihe dazu ein ungesteuertes Ventil vorgesehen. Die Stromflussrichtung der beiden Ventile ist gegenläufig. Jede Arbeitswicklung ist über einen sättigbaren Transduktor-Kern mit einer Transduktor-Steuerwicklung magnetisch gekoppelt, wobei der Steuerwicklung ein Steuersignal zugeleitet ist. Der Sättigungszustand des Transduktor-Kerns und damit der Schaltzustand des "magnetic valve" sind durch das Steuersignal vorgebbar. In Verbindung mit der gegenläufigen Anordnung der Ventile wird erreicht, dass einem DC-Anteil je nach Stromrichtung ein gegengleicher DC-Kompensation entgegen gesetzt wird.

Eine vergleichsweise hierzu kostengünstigere Ausführung kann so konstruiert sein, dass die Transduktor-Schaltung eine einzige Arbeitswicklung aufweist, die in Reihe mit einem einzigen Ventil und einer Schaltvorrichtung, zur Umpolung der Stromflussrichtung des Ventils, angeordnet ist. Auch hier ist diese Arbeitswicklung der Transduktor-Schaltung über einen weichmagnetischen Transduktor-Kern mit einer Steuerwicklung magnetisch gekoppelt. In die Steuerwicklung wird ein Steuersignal eingespeist, dessen Information eine Erfassungseinrichtung bereitstellt, die Größe und Richtung des zu kompensierenden Gleichstromanteils erfasst. Hierbei ist durch Umpolung dieses einzigen Ventils wieder die Kompensation eines DC-Anteils in beiden Richtungen möglich.

Zur Senkung der Herstellungskosten kann es für jede dieser Ausführungsformen günstig sein, wenn der Transduktor-Kern als Spaltbandkern ausgebildet ist.

Um die für die Steuerung der Transduktor-Schaltung erforderliche Steuerleistung möglichst gering zu halten, kann es vorteilhaft sein, wenn der Spaltbandkern aus Blechlamellen eines weichmagnetischen Werkstoffs hergestellt ist, der eine im Wesentlichen schmale rechteckförmige Hystereseschleife aufweist. Die Steuer- und Regeleinrichtung kann dadurch einfacher aufgebaut werden.

Eine weitere Reduktion der Steuerleistung kann dadurch erreicht werden, in dem der Transduktor-Kern in einem magnetischen Kreis angeordnet ist, der zumindest einen Luftspalt aufweist. Dadurch kommt es zu einer Schrägstellung der Hystereseschleife, so dass die magnetische Flussdichte auf kleiner / gleich 20 % der Sättigungsflussdichte begrenzt ist.

Besonders günstig kann eine Schaltungsanordnung sein, bei der die Erfassungseinrichtung, die den störenden DC-Anteil in Größe und Richtung erfasst, als Magnetfeld-Messeinrichtung ausgebildet ist. Eine solche Magnetfeld-Messeinrichtung kann im Inneren des Kessels am Transformatorkern anliegend angeordnet sein. Dadurch wird lediglich ein Signalstrang aus dem Inneren des Transformatorkessels (zur Steuer- und Regeleinrichtung) herausgeführt, nicht aber ein Leistungsstrang. Eine Nachrüstung kann mit vergleichsweise geringen Kosten realisiert werden.

Eine solche Magnetfeld-Messeinrichtung ist beispielsweise aus PCT/EP 2010/054857 bekannt. Sie weist ein C-förmiges Nebenschlussteil auf, dessen Schenkel zum Kern des Transformators gerichtet sind, so dass von diesem ein magnetischer Teilflusses abgezweigt wird. Der abgezweigte Teilfluss induziert in einer am Nebenschlussteil vorgesehenen Sensorspule eine elektrische Spannung, die als Signal den zu kompensierenden Gleichflussanteil im Kern abbildet.

Mit anderen Worten, der vorliegende Lösungsansatz ermöglicht es, dass ein im Netz in Betrieb befindlicher Transformator nachträglich auf einfache und kostengünstige Weise mit der Funktionalität eines DC-Schutzes ausgestattet werden kann. Nicht eine Kompensationswicklung, sondern lediglich eine Messeinrichtung muss im Transformatorgehäuse installiert werden, sofern die Information über den zu kompensierenden DC-Anteil nicht von einer anderen Erfassungseinrichtung kommt. Damit ist auch bei bereits in Betrieb befindlichen Transformatoren die Installation einer DC-Kompensation mit vergleichsweise geringem Aufwand auch nachträglich möglich. Bislang war eine solche Nachrüstung aus Kostengründen kaum vertretbar.

Es erscheint günstig, wenn jede Diode als hochsperrende Leistungsdiode ausgebildet ist, die eine hohe Sperrfähigkeit und einen niedrigen Durchlasswiderstand aufweist. Dies kann durch eine Bauform einer Diode erreicht werden, bei der zwischen hochdotierten pn-Zonen eine dünne niedrig dotierte Zwischenschicht ausgebildet ist.

Um den elektrischen Strom im durchgeschalteten Zustand des Transduktors zu begrenzen, kann es günstig sein, wenn im Strompfad (Leistungsstrang) eine in Reihe zur Arbeitswicklung der Transduktor-Schaltung angeordnete Strombegrenzungsdrossel angeordnet ist. Diese Strombegrenzungsdrossel kann wie ein "Shuntreactor" für vergleichsweise geringen Strom und geringe Leistung ausgelegt werden. Die Steuer- und Regeleinrichtung kann dadurch einfacher ausgeführt werden, da der sonst vorzusehende sicherheitstechnische Aufwand geringer ist.

In einer Alternative hierzu kann es aber auch vorteilhaft sein, wenn jede der parallel geschalteten Arbeitswicklungen bzw. die einzige Arbeitswicklung der Transduktor-Schalteinrichtung zur Strombegrenzung im Strompfad ausgelegt ist. Eine separate Strombegrenzunsdrossel ist dann nicht erforderlich. Auch hier kann die Steuer- und Regeleinrichtung einfacher aufgebaut werden.

Die Erfindung betrifft auch ein Verfahren zum Kompensieren eines Gleichstromanteils in einer Wicklungsanordnung eines Transformators, wobei die Wicklungsanordnung mittels Anschlussleiter an ein Netz zum Transport von elektrischer Energie angeschlossen ist, und wobei eine der oben näher erläuterten Schaltungsanordnung verwendet wird.

### Kurzbeschreibung der Zeichnung

Zur weiteren Erläuterung der Erfindung wird im nachfolgenden Teil der Beschreibung auf Zeichnungen Bezug genommen, aus denen weitere vorteilhafte Ausgestaltungen, Einzelheiten und Weiterbildungen der Erfindung anhand eines nicht einschränkenden Ausführungsbeispiels zu entnehmen sind.

Es zeigen:
- Figur 1: ein vereinfachtes Schaltbild einer Schaltungsanordnung gemäß einer ersten Ausführung der Erfindung;
- Figur 2: ein vereinfachtes Schaltbild einer Schaltungsanordnung gemäß einer zweiten Ausführung der Erfindung.

### Ausführung der Erfindung

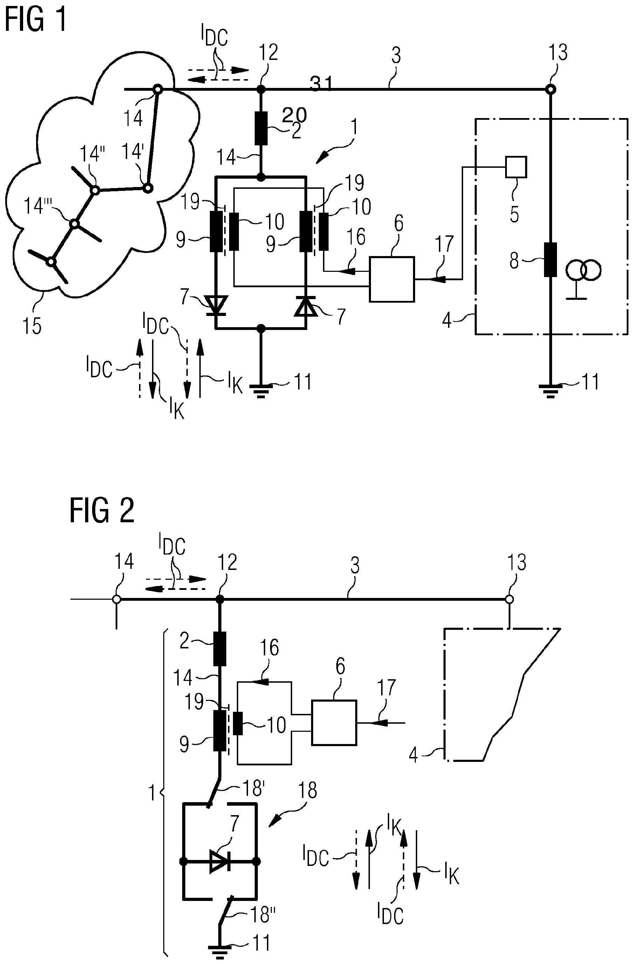

Figur 1 zeigt ein vereinfachtes Schaltbild einer ersten Ausführung der erfindungsgemäßen Schaltungsanordnung. Diese besteht im Wesentlichen aus einer Transduktor-Schaltung 1, die in einem Strompfad 20 angeordnet ist. Der Strompfad 20 verbindet einen Anschlusspunkt 12, der auf einer Zuleitung 3 zum Transformator 4 liegt, mit Erdpotential 11. Der Einfachheit wegen ist in Figur 1 nur eine der Zuleitungen 3 gezeichnet, stellvertretend für die drei Leiter des 3-Phasensystems. Vom Wicklungssystem des Transformators 4 ist ebenfalls der Übersichtlichkeit wegen nur eine Wicklung 8 dargestellt. Der Sternpunkt des Transformators 4 ist geerdet, d.h. mit dem Erdungspunkt 11 verbunden. Sowohl die Zuleitungen 3 als auch der Strompfad 20 sind zeichnerisch durch eine dicke Linienführung hervorgehoben (Leistungspfad); mit einer dünnen Strichstärke ist in den Zeichnungen der Figur 1 und der Figur 2 die Leitungsführung der Messsignal 17 und Steuersignale 16 dargestellt (Messsignal-und Steuerungspfad).

Im Beispiel der Figur 1 ist der Transformator ein Verteilungstransformator an der Schnittstelle zwischen einem Hochspannungsnetz und einem Mittelspannungsnetz. Normalerweise sind solche Verteilungstransformatoren in der Schaltgrupp Yy0 ausgeführt, d.h. mit geerdetem Sternpunkt. Auch Ortsnetztransformatoren haben üblicherweise einen zugängigen Sternpunkt, z.B. in der Schaltgruppe Yz5.

Der Anschlusspunkt 12 liegt auf einem Zuleitungsabschnitt 31 zwischen einem Anschluss-Knotenpunkt 14 und einem Transformatoranschluss 13. Der Knotenpunkt 14 ist Teil eines Netzes 15 zur Erzeugung, Übertragung und Verteilung elektrischer Energie, das auch weiter Knotenpunkte 14', 14", 14"' umfasst. Zwischen dem Anschluss-Netzknoten 14 und dem Transformatoranschluss 13 befinden sich keine weiteren Netzknoten, d.h. der Abschnitt 31 des Dreiphasen-Leitungssystems 3 ist knotenfrei.

Es sei nun davon ausgegangen, dass auf den Zuleitungen 3 ein DC-Anteil (I_{DC}) fließt (in Figur 1 durch einen Doppelpfeil dargestellt). Die Stromflussrichtung des DC-Anteils (I_{DC}) ist zum Transformator bzw. vom Transformator weg gerichtet. Wie eingangs bereits dargestellt, ist dieser DC-Anteil für den Transformator 4 höchst unerwünscht. Gemäß dem vorliegenden Lösungsansatz wird diesem DC-Anteil bereits vor Eintritt in den Transformator 4 entgegengewirkt. Ähnlich einer Weiche wird der DC-Anteil auf Erde 11 abgeleitet, so dass es gar nicht dazu kommt, dass er seine störende Auswirkung im Kern des Transformators entfalten kann. Im Gegensatz zu bekannten Lösungskonzepten der DC-Kompensation, bei denen eine Kompensationswicklung im Inneren des Transformatorgehäuses vorausgesetzt wird, ist hier keine separate Kompensationswicklung erforderlich, sondern es wird der Gleichstrom an der Zuleitung abgeleitet. Bewerkstelligt wird diese Ableitung im Wesentlichen durch eine Transduktor-Schaltung 1, die wie eine Schutzeinrichtung für den Transformator wirkt.

Die Transduktor-Schaltung 1 fungiert als magnetischer Schalter oder "magnetic valve" und ist von einer Steuer- und Regeleinheit 6 gesteuert. Im durchgeschalteten Zustand erfolgt die Strombegrenzung durch eine Drossel 2, die in einer Reihenschaltung mit der Transduktor-Schaltung 1 liegt. Die Steuer- und Regeleinheit 6 umfasst eine Recheneinheit mit einem darauf ablauffähigen Algorithmus. Dieser erzeugt das Steuersignal 16, wobei das eingangsseitig zugeführte Messsignals 17 verwendet wird. Das Messsignal 17 ist ein Abbild für den zu kompensierenden DC-Anteil und wird von einem Magnetfeldsensor 5 bereitgestellt. Dieser Magnetfeldsensor 5 ist im Innenraum des Transformators 4 angeordnet, wo er einen im Kern des Transformators fließenden magnetischen Gleichflussanteil, der vom DC-Anteil herrührt, misst. Ein solcher Magnetfeldsensor ist in PCT/EP 2010/054857 beschrieben.

Die Transduktor-Schaltung 1 ermöglicht die Kompensation auch von vergleichsweise hohen GIC-Gleichströmen, die mehr als 50A betragen können. In der in Figur 1 gezeigten Ausführung besteht die Transduktor-Schaltung 1 aus zwei parallelen Stromzweigen, in denen jeweils eine Transduktor-Arbeitswicklung 9 und jeweils eine Diode 7 in Reihe angeordnet ist. Die beiden Dioden 7 in den Parallelzweigen sind antiparallel (Durchlassrichtung ist gegenläufig) angeordnet, das heißt in der Darstellung der Figur 1 zeigt im linken Zweig die Diode 7 in Richtung Erde 11, im rechten Zweig zeigt die Diode 7 in Richtung der Zuleitung 3. Jede Arbeitswicklung 9 in den Parallelenzweigen ist über einen sättigungsfähigen Transduktor-Kern 19 mit einer zugeordneten Transduktor-Steuerwicklung 10 magnetisch gekoppelt. Die beiden Steuerwicklungen 10 sind in einem Steuerkreis in Serie hintereinander angeordnet. In den Steuerkreis wird das Steuersignal 16 eingespeist, so dass der Sättigungszustand des Transduktor-Kerns 19 und damit der Stromfluss im Strompfad 20 vorgebbar ist. Je nach Steuersignal 16 kann erreicht werden, dass sich im Strompfad 20 (Leistungspfad) ein Kompensationsstrom I_{K} in der einen oder in der anderen Richtung ausbildet (entweder vom Anschlusspunkt 12 in Richtung Erde 11, oder umgekehrt). Mit diesem bidirektionalen Kompensationsstrom I_{K} (Mischstrom mit Oberschwingungen) im Strompfad 20 wird dem störenden Gleichflussanteil im Kern des Transformators entgegengewirkt, bzw. vollständig kompensiert. In der Darstellung der Figur 1 ist die vollständige DC-Kompensation jeweils durch zwei gleich große Pfeile dargestellt: der Kompensationsstrom I_{K} (durchgezogener Pfeil) ist jeweils einem gleichgroßen Gleichstromanteil I_{DC} (unterbrochene Pfeil) entgegen gerichtet.

Die Figur 2 zeigt einen anders ausgeführten Lösungsansatz. Im Gegensatz zu Figur 1 besteht hier die Transduktor-Schaltung 1 nicht aus zwei Transduktor-Arbeitswicklungen, sondern aus einer einzigen Arbeitswicklung 9 und einer ihr zugeordneten Transduktor-Steuerwicklung 10. Die Arbeitswicklung 9 und die Steuerwicklung 10 sind wieder mittels eines sättigungsfähigen Transduktor-Kerns 19 magnetisch gekoppelt. Die Steuerwicklung 10 liegt in einem Steuerkreis in welchem das Steuersignal 16 eingespeist ist. (Der Steuerkreis ist in Figur 2 mit einer dünnen Linienführung zeichnerisch dargestellt). Das Steuersignal 16 wird wieder von einer Steuer- und Regeleinheit 6 ausgangsseitig bereitgestellt. Eingangsseitig ist dieser Steuer- und Regeleinheit 6 das Messsignal 17 zugeführt, so dass auch bei dieser Ausführung der Erfindung die Information über Größe und Richtung des zu kompensierenden DC-Anteils in der Steuer- und Regeleinheit 6 vorliegt. Das Steuersignal 16 gibt wieder den Sättigungszustand des Transduktor-Kerns 19 so vor, dass der induktiv wirkende Schalter 1 in geeigneter Weise leitend gemacht wird, wodurch der Stromfluss im Strompfad 20 vorgebbar ist (gegengleicher oberschwingungsbehafteter Strom zu I_{DC}).

In Reihe zur Arbeitswicklung 9 liegt eine Schaltvorrichtung 18, die einen ersten Schaltkontakt 18' und einen zweiten Schaltkontakt 18" aufweist. Zwischen diesen Schaltkontakten 18', 18" ist eine einzige Diode 7 angeordnet. In der gezeigten Schaltstellung ist der erste Schaltkontakt 18' mit der Anode der Diode 7 verbunden, der zweite Schaltkontakt 18" mit der Kathode. Je nach Schaltstellung dieser beiden Schaltkontakte 18', 18" kann die Diode 7 umgepolt werden. Damit ist auch bei dieser Schaltungsvariante, bei der nur ein einziges ungesteuertes Ventil 7 verwendet wird, eine bidirektionale Kompensation eines DC-Anteils möglich. (Siehe Doppelpfeil in Figur 2).

Die Betätigung der Schaltvorrichtung 18 kann auf unterschiedliche Weise erfolgen, z.B. durch einen Aktuator oder einen Motor, denkbar ist auch ein manueller Betrieb.

Mit dem Bezugszeichen 3 ist in Figur 2 wieder der Übersichtlichkeit wegen nur ein Leiter des 3-Phasen-Systems dargestellt. Der Abschnitt 31 der Leitungen 3 liegt wieder zwischen einem Netzknoten 14 eines Energieversorgungsnetzes 15 und einem Anschlusspunkt 13 des Transformators 4. Zwischen diesen beiden Punkten ist der Zuleitungs-Abschnitt 31 zum Transformator 4 knotenfrei. Die Schaltungsanordnung 1 befindet sich in örtlicher Nähe zum Transformator 4, z.B. in einer Transformatorstation.

In den Figuren 1 und 2 kennzeichnen gleiche Bezugszeichen identische oder hinsichtlich der Funktion ähnliche Elemente. Sowohl in der Ausführung gemäß Figur 1, als auch in der Ausführung gemäß Figur 2 ist im Strompfad 20 eine Strombegrenzunsdrossel 2 gezeichnet. Es wäre aber auch möglich, dass die beiden Arbeitswicklungen 9 bzw. die eine Arbeitswicklung 9 so ausgelegt sind bzw. ist, dass im durchgeschalteten Zustand des "magnetic valve" der elektrische Strom im Strompfad 20 begrenzt ist.

In beiden Ausführungsformen erfolgt die DC-Schutzwirkung nach dem Prinzip einer Gleichstromweiche, direkt an der Zuleitung, d.h. der Kompensationsstrom I_{K} muss nur die gegengleiche Größe des störenden Gleichstroms auf der Zuleitung 31 haben.

Von besonderem Vorteil ist dabei, dass mit der vorliegenden Schaltungsanordnung auch hohe Gleichströme von über 50 A, wie sie bei GIC auftreten können, entgegen gewirkt werden kann.

Beide Ausführungsformen haben den wesentlichen Vorteil, dass der Einbau einer Kompensationswicklung nicht erforderlich ist, weder nachträglich im Rahmen einer Nachrüstung, noch bei der Herstellung des Transformators.

Für einen bereits in Betrieb befindlichen Transformator ergibt sich der wesentlichen Vorteil, dass erstmals überhaupt eine DC-Schutz / DC-Kompensation mit vertretbarem Kostenaufwand realisierbar ist.

Bei der Herstellung eines Transformators entfällt der Einbauraum, der für die Kompensationswicklung sonst erforderlich wäre. Damit ergibt sich eine kompakte Bauweise. Von besonderem Vorteil ist dies insbesondere wenn hohe GIC-Ströme kompensiert werden sollen, da in diesem Fall die Kompensationswicklung vergleichsweise voluminös ist und ein entsprechend großer Einbauraum vorgesehen werden muss.

Da die Schaltungsanordnung keine aktive Leistungselektronik aufweist, sondern nur passiv wirkende Baukomponenten, kann sie leicht für hohe Spannungen dimensioniert werden. Der induktive Schalter 1 ist im Prinzip ein Transformator im Leerlauf, bei dem die volle Spannung (110 KV, 220 KV 340 KV, etc.) gegen Erde abfällt. Er kann mit vergleichsweise geringen Kosten realisiert werden. Die übrigen Baukomponenten sind im Transformatorbau üblich bzw. kommerziell verfügbar.

Obwohl die Erfindung im Detail durch die beiden bevorzugten Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

### Zusammenstellung der verwendeten Bezugszeichen

- 1: Transduktor-Schaltung
- 2: Strombegrenzungsdrossel
- 3: Anschlussleiter
- 4: Transformator mit geerdeten Sternpunkt
- 5: Messeinrichtung für I_{DC}
- 6: Steuer- und Regeleinrichtung
- 7: Diode
- 8: Wicklung des Transformators
- 9: Arbeitswicklung
- 10: Steuerwicklung
- 11: Erde, Erdungspunkt
- 12: Anschlusspunkt
- 13: Transformatoranschluss
- 14: Netzknoten
- 14': Netzknoten
- 14": Netzknoten
- 15: Netz
- 16: Steuersignal
- 17: Messsignal
- 18: Schaltvorrichtung
- 18": Schaltkontakt
- 18": Schaltkontakt
- 19: Transduktor-Kern
- 20: Strompfad

- 31: Abschnitt von 3 (knotenfrei)

- I_{DC}: Gleichstromanteil, DC-Anteil
- I_{K}: Kompensationsstrom

## Patentansprüche

1. Schaltungsanordnung zur Kompensation eines Gleichstromanteils (I_{DC}) in einem Transformator (4), wobei der Transformator (4) eine Wicklungsanordnung (8) die mittels Anschlussleiter (3) an ein Netz (15) zum Transport von elektrischer Energie anschliessbar ist und einen mit Erde (11) verbundenen Sternpunkt aufweist, umfassend:
- eine Transduktor-Schaltung (1), welche in einem Strompfad (20) angeordnet ist, der einen auf einem knotenfreien Abschnitt (31) der Anschlussleiter (3) liegenden Anschlusspunkt (12) mit Erde (11) verbindet,
- eine Steuer- und Regeleinrichtung (6), welche die Transduktor-Schaltung (1) mittels eines Steuersignals (16) steuert und welcher eingangsseitig ein von einer Erfassungseinrichtung (5) bereitgestelltes Signal (17) über Größe und Richtung des zu kompensierenden Gleichstromanteils(I_{DC}) zugeleitet ist.

2. Schaltungsanordnung nach Anspruch 1, **dadurch gekennzeichnet, dass** die Transduktor-Schaltung (1) zwei parallele Stromzweige aufweist, in denen jeweils eine Arbeitswicklung (9) und ein ungesteuertes Ventil (7) angeordnet ist, wobei die Ventile antiparallel geschaltet sind, wobei jede Arbeitswicklung (9) mit einer zugeordneten Steuerwicklung (10) über einen Transduktor-Kern (19) magnetisch gekoppelt ist, wobei das Steuersignal (16) der Steuerwicklung (10) zugeleitet ist.

3. Schaltungsanordnung nach Anspruch 1, **dadurch gekennzeichnet, dass** die Transduktor-Schaltung (1) eine einzige Arbeitswicklung (9) aufweist, die in Reihe mit einer Schaltvorrichtung (18) zur Umpolung der Stromflussrichtung eines einzigen Ventils (7) angeordnet ist, und wobei die Arbeitswicklung (9) mit einer zugeordneten Steuerwicklung (10) über einen Transduktor-Kern (19) magnetisch gekoppelt ist.

4. Schaltungsanordnung nach einem der Ansprüche 1 oder 2 oder 3, **dadurch gekennzeichnet, dass** der Transduktor-Kern (19) als Spaltbandkern ausgebildet ist.

5. Schaltungsanordnung nach Anspruch 4, **dadurch gekennzeichnet, dass** der Spaltbandkern (19) aus Blechlamellen eines weichmagnetischen Werkstoffs hergestellt ist, der eine im Wesentlichen schmale, rechteckförmige Hystereseschleife aufweist.

6. Schaltungsanordnung nach Anspruch 5, **dadurch gekennzeichnet, dass** der Transduktor-Kern (19) in einem magnetischen Kreis angeordnet ist, der zumindest einen Luftspalt aufweist, so dass die magnetische Flussdichte auf kleiner oder gleich 20 % der Sättigungsflussdichte begrenzt ist.

7. Schaltungsanordnung nach Anspruch 1 oder 2 oder 3, **dadurch gekennzeichnet, dass** die Erfassungseinrichtung (5) eine Magnetfeld-Messeinrichtung ist, die am Kern des Transformators (4) angeordnet ist, um einen durch den Gleichstromanteil (I_{DC}) im Kern verursachten magnetischen Gleichflussanteil zu messen.

8. Schaltungsanordnung nach Anspruch 7, **dadurch gekennzeichnet, dass** die Magnetfeld-Messeinrichtung (5) einen Nebenschlussteil aufweist, der vom Kern des Transformators (4) einen magnetischen Teilfluss abzweigt, so dass in einer am Nebenschlussteil vorgesehenen Sensorspule eine elektrische Spannung induziert wird, wodurch das Messsignal (17) gebildet ist.

9. Schaltungsanordnung nach Anspruch 2 oder 3, **dadurch gekennzeichnet, dass** jedes der beiden Ventile (7) bzw. das einzige Ventil als hochsperrende Leistungsdiode ausgebildet ist.

10. Schaltungsanordnung nach Anspruch 2 oder 3, **dadurch gekennzeichnet, dass** im Strompfad (20) in Reihe zur Transduktor-Schaltung (1) eine Strombegrenzungsdrossel (2) vorgesehen ist.

11. Schaltungsanordnung nach Anspruch 2 oder 3, **dadurch gekennzeichnet, dass** jede der parallel geschalteten beiden Arbeitswicklungen (9) bzw. die einzige Arbeitswicklung (9) zur Strombegrenzung im Strompfad (20) ausgelegt ist.

12. Verfahren zum Kompensieren eines Gleichstromanteils (I_{DC}) in einer Wicklungsanordnung (8) eines Transformators (4),
- wobei die Wicklungsanordnung (8) mittels Anschlussleiter (3) an ein Netz (15) zum Transport von elektrischer Energie anschliessbar ist,
- wobei die Wicklungsanordnung (8) einen mit Erde (11) verbundenen Sternpunkt aufweist, und
- wobei eine Schaltungsanordnung nach einem der Ansprüche 1-11 verwendet wird.

## Claims

1. Circuit arrangement for compensation of a DC component (I_{DC}) in a transformer (4), wherein the transformer (4) has a winding arrangement (8) which can be connected by means of connecting lines (3) to a power system (15) for transporting electrical energy and has a neutral point connected to earth (11), comprising:
- a transductor circuit (1) which is arranged in a current path (20) which connects a connection point (12) situated on a node-free portion (31) of the connection line (3) to earth (11),
- a control and regulation device (6) which controls the transductor circuit (1) by means of a control signal (16) and to which is fed, on the input side, a signal (17) provided by a detection device (5) concerning the size and direction of the DC component (I_{DC}) to be compensated.

2. Circuit arrangement according to claim 1, **characterised in that** the transductor circuit (1) has two parallel current branches in each of which a load winding (9) and an uncontrolled valve (7) is arranged, wherein the valves are connected antiparallel, wherein each load winding (9) is magnetically coupled to an associated control winding (10) via a transductor core (19), wherein the control signal (16) is fed to the control winding (10).

3. Circuit arrangement according to claim 1, **characterised in that** the transductor circuit (1) has a single load winding (9) which is arranged in series with a switching device (18) for reverse-poling the current flow direction of a single valve (7) and wherein the load winding (9) is magnetically coupled to an associated control winding (10) via a transductor core (19).

4. Circuit arrangement according to one of claims 1 or 2 or 3, **characterised in that** the transductor core (19) is embodied as a slit strip core.

5. Circuit arrangement according to claim 4, **characterised in that** the slit strip core (19) is made of sheet metal lamellae of a soft magnetic material which has an essentially narrow rectangular hysteresis loop.

6. Circuit arrangement according to claim 5, **characterised in that** the transductor core (19) is arranged in a magnetic circuit which has at least one air gap, so that the magnetic flux density is limited to less than or equal to 20% of the saturation flux density.

7. Circuit arrangement according to claim 1 or 2 or 3, **characterised in that** the detection device (5) is a magnetic field measuring device which is arranged on the core of the transformer (4) in order to measure a magnetic unidirectional flux portion caused in the core by the DC component (I_{DC}).

8. Circuit arrangement according to claim 7, **characterised in that** the magnetic field measuring device (5) comprises a shunt component which diverts a magnetic partial flux from the core of the transformer (4), so that an electrical voltage is induced in a sensor coil provided at the shunt component, by which means the measurement signal (17) is formed.

9. Circuit arrangement according to claim 2 or 3, **characterised in that** each of the two valves (7) or the single valve is embodied as a high-blocking power diode.

10. Circuit arrangement according to claim 2 or 3, **characterised in that** a current-limiting reactor (2) is provided in the current path (20) in series with the transductor circuit (1).

11. Circuit arrangement according to claim 2 or 3, **characterised in that** each of the two parallel-connected load windings (9) or the single load winding (9) is configured for current limitation in the current path (20) .

12. Method for compensating for a DC component (I_{DC}) in a winding arrangement (8) of a transformer (4),
- wherein the winding arrangement (8) can be connected by means of connecting lines (3) to a power system (15) for transporting electrical energy,
- wherein the winding arrangement (8) has a neutral point connected to earth (11), and
- wherein a circuit arrangement according to one of claims 1-11 is used.

## Revendications

1. Agencement de circuit destiné à la compensation d'une partie de courant continu (I_{DC}) dans un transformateur (4), dans lequel le transformateur (4) est un agencement d'enroulement (8) qui peut être raccordé à un réseau (15) en vue du transport d'énergie électrique au moyen de conducteurs de raccordement (3) et présente un point neutre relié à la terre (11), comprenant :
- un circuit de transducteur (1), lequel est disposé dans un trajet de courant (20) qui relie un point de raccordement (12) qui se trouve sur une section exempte de noeuds (31) des conducteurs de raccordement (3) à la terre (11),
- un dispositif de commande et de réglage (6), lequel commande le circuit de transducteur (1) au moyen d'un signal de commande (16) et auquel est transmis côté entrée un signal (17) mis à disposition par un dispositif d'acquisition (5) concernant la taille et la direction de la partie de courant continu (I_{DC}) à compenser.

2. Agencement de circuit selon la revendication 1, **caractérisé en ce que** le circuit de transducteur (1) présente deux branches de courant parallèles, dans lesquelles respectivement un enroulement de travail (9) et un clapet non commandé (7) sont disposés, dans lequel les clapets sont montés de manière antiparallèle, dans lequel chaque enroulement de travail (9) est couplé magnétiquement avec un enroulement de commande associé (10) via un noyau de transducteur (19), dans lequel le signal de commande (16) est transmis à l'enroulement de commande (10).

3. Agencement de circuit selon la revendication 1, **caractérisé en ce que** le circuit de transducteur (1) présente un enroulement de travail unique (9) qui est disposé en série avec un dispositif de commutation (18) en vue d'une inversion de polarité de la direction de circulation de courant d'un clapet unique (7), et dans lequel l'enroulement de travail (9) est couplé magnétiquement à un enroulement de commande associé (10) via un noyau de transducteur (19).

4. Agencement de circuit selon l'une des revendications 1 ou 2 ou 3, **caractérisé en ce que** le noyau de transducteur (19) est réalisé en tant que noyau de bobine refendue.

5. Agencement de circuit selon la revendication 4, **caractérisé en ce que** le noyau de bobine refendue (19) est fabriqué à partir de lamelles de tôle d'un matériau magnétique doux qui présente une boucle d'hystérésis pour l'essentiel étroite et de forme rectangulaire.

6. Agencement de circuit selon la revendication 5, **caractérisé en ce que** le noyau de transducteur (19) est disposé dans un circuit magnétique qui présente au moins un entrefer de sorte que la densité de flux magnétique est limitée à 20 % ou moins de la densité de flux de saturation.

7. Agencement de circuit selon la revendication 1 ou 2 ou 3, **caractérisé en ce que** le dispositif d'acquisition (5) est un dispositif de mesure de champ magnétique qui est disposé au niveau du noyau du transformateur (4) pour mesurer une partie de flux continu magnétique provoquée par le biais de la partie de courant continu (I_{DC}) dans le noyau.

8. Agencement de circuit selon la revendication 7, **caractérisé en ce que** le dispositif de mesure de champ magnétique (5) présente une partie de shunt magnétique qui fait bifurquer une partie du flux magnétique du noyau du transformateur (4) de sorte qu'une tension électrique est induite dans une bobine de capteur prévue au niveau de la partie de shunt magnétique, moyennant quoi le signal de mesure (17) est formé.

9. Agencement de circuit selon la revendication 2 ou 3, **caractérisé en ce que** chacun des deux clapets (7) ou l'unique clapet est réalisé en tant que diode de puissance produisant un blocage intense.

10. Agencement de circuit selon la revendication 2 ou 3, **caractérisé en ce que** dans le trajet de courant (20) une inductance de protection contre le courant (2) est prévue en série par rapport au circuit de transducteur (1).

11. Agencement de circuit selon la revendication 2 ou 3, **caractérisé en ce que** chacun des deux enroulements de travail (9) montés en parallèle ou l'unique enroulement de travail (9) en vue de la limitation de courant sont dimensionnés dans le trajet de courant (20).

12. Procédé destiné à la compensation d'une partie de courant continu (I_{DC}) dans un agencement d'enroulement (8) d'un transformateur (4),
- dans lequel l'agencement d'enroulement (8) peut être raccordé à un réseau (15) en vue du transport d'énergie électrique au moyen de conducteurs de raccordement (3),
- dans lequel l'agencement d'enroulement (8) présente un point neutre relié à la terre (11), et
- dans lequel un agencement de circuit selon l'une des revendications 1-11 est utilisé.
